# EUROPÄISCHE PATENTSCHRIFT

(11) **EP 2 349 885 B1**
(45) Veröffentlichungstag und Bekanntmachung des Hinweises auf die Patenterteilung: **01.08.2012**
(21) Anmeldenummer: 09759651.4
(22) Anmeldetag: 27.10.2009
(51) Int. Cl.: B65G 47/90

(54) **HANDHABUNGSVORRICHTUNG FÜR GEGENSTÄNDE MIT PLANEN, INSBESONDERE GLATTEN OBERFLÄCHEN**
HANDLING DEVICE FOR ARTICLES HAVING PLANAR, ESPECIALLY SMOOTH SURFACES
DISPOSITIF DE MANIPULATION D'OBJETS À SURFACES PLANES, EN PARTICULIER LISSES

(30) Priorität: 27.10.2008 DE 102008053278
(43) Veröffentlichungstag der Anmeldung: 03.08.2011
(73) Patentinhaber: Rheinisch-Westfälisch-Technische Hochschule Aachen, 52062 Aachen (DE)
(72) Erfinder: PRUST, David Josef Ludwig, 52062 Aachen (DE); DIX, Daniel, 34613 Schwalmstadt (DE); LÖHR, Christian, 52064 Aachen (DE)
(74) Vertreter: Borkowski, Jens
(86) Internationale Anmeldenummer: PCT/EP2009/007665
(87) Internationale Veröffentlichungsnummer: WO 2010/049117

(56) Entgegenhaltungen:
- DD-A1- 250 914
- DE-A1- 10 251 064

## Beschreibung

Die Erfindung betrifft eine Handhabungsvorrichtung für Gegenstände mit planen, insbesondere glatten Oberflächen.

Handhabungsvorrichtungen für solche Gegenstände sind grundsätzlich im Stand der Technik bekannt und beruhen im Wesentlichen allgemein darauf, eine Wirkverbindung zwischen einer Handhabungsvorrichtung und einem handzuhabenden Gegenstand zu erzeugen. Bekannt ist dies beispielsweise bei der Handhabung von planen, insbesondere glatten Platten, wie sie bei Glasscheiben, Wafern, LCD-Flächen oder sonstigen möglichen Elementen vorkommen.

Eine dabei gängige Art, eine Wirkverbindung zwischen der Handhabungsvorrichtung und einem handzuhabenden Gegenstand zu erzielen, ist das Arbeiten mit Unterdruck, so dass solche Handhabungsvorrichtungen üblicherweise wenigstens einen Saugnapf aufweisen, der an die Oberfläche eines handzuhabenden Gegenstandes angelegt werden kann, um sodann den Zwischenraum, der durch das Anlegen entsteht, zu evakuieren oder zumindest zu vergrößern und so einen Unterdruck zu erzeugen, so dass die Handhabungsvorrichtung mit dem handzuhabenden Gegenstand verbunden ist und somit der Gegenstand durch die Bewegung der Handhabungsvorrichtung im Raum, zumindest jedoch in einer Ebene, bewegt werden kann.

Typische Anwendungsgebiete sind beispielsweise Transportvorrichtungen, mit denen Gegenstände mit planen, insbesondere glatten Oberflächen, wie die eingangs genannten Glasscheiben oder auch Scheiben aus anderen Materialien, Wafer, LCD-Flächen etc. z.B. in einer Fertigungs- oder Verarbeitungsstraße bewegt werden können. Ein Schreitantrieb kann z.B. eine solche Transportvorrichtung bilden.

Das Dokument DD 2 50 914 A1 offenbart eine Handhabungsvorrichtung gemäß dem Obergriff des Anspruchs 1.

Um eine ausreichende Haftkraft der Adhäsionsfolie in einem Zustand zu erzielen, wenn diese mittels des Handhabungselementes an die Oberfläche eines Gegenstandes angelegt ist, gleichzeitig jedoch ein einfaches, insbesondere abschälendes Ablösen von der Oberfläche zu erzielen, ist es vorgesehen, dass die Adhäsionsfolie einen inneren Bereich aufweist, von dem sich die Adhäsionsfolie mit wenigstens zwei Armen nach außen erstreckt. Dabei ist es vorgesehen, dass dieser innere Bereich der Adhäsionsfolie lose zum Handhabungselement angeordnet ist, die äußeren Enden der wenigstens zwei Arme hingegen am und/oder im Handhabungselement befestigt sind. Dabei muss es sich jedoch nicht zwingend um eine starre Befestigung handeln, sondern es kann hier auch eine Befestigung vorgesehen sein, die eine relative Beweglichkeit zwischen Handhabungselement und äußerem Ende jedes Armes ermöglicht. Beispielsweise kann es sich demnach um eine elastische oder federnde oder gelenkige oder ähnlich geartete Befestigung zwischen dem Ende eines Armes der Adhäsionsfolie und dem Handhabungselement handeln.

Hierbei wird gemäß einem ersten erfindungsgemäßen Aspekt eine Adhäsionsfolie eingesetzt, bei der es nach dem Anlegen der Folie an eine Oberfläche eines Gegenstandes zu einer Wechselwirkung zwischen der Adhäsionsfolie und der Oberfläche, z.B. zwischen den Molekülen der Adhäsionsfolie und denen der Oberfläche des handzuhabenden Gegenstandes kommt, wobei es sich bei einer solchen Wechselwirkung insbesondere um Van der Waals-Kräfte handeln kann.

Unter Adhäsionsfolien im Sinne der Erfindung werden jedoch auch weiterhin Folien verstanden, die z.B. eine Nanostrukturierung aufweisen, wie sie beispielsweise aus dem Tierreich von Füßen der Geckos bekannt sind. Unter einer Adhäsionsfolie werden somit jegliche Folien verstanden, die nach dem Anlegen an die Oberfläche eines Gegenstandes ohne zwischengefügte Klebstoffe oder sonstige Hilfsmittel eine Wirkverbindung mit der Oberfläche des Gegenstandes eingehen, insbesondere aufgrund derer zumindest eine Manipulation, d.h. Bewegung des Gegenstandes mit der Handhabungsvorrichtung in einer Ebene, hier insbesondere in der Ebene des planen, flächigen Gegenstandes möglich ist.

Gemäß einem weiteren erfindungsgemäßen Aspekt ist es dabei wie eingangs genannt vorgesehen, dass die Adhäsionsfolie an einem Handhabungselement nicht vollständig befestigt ist, sondern lediglich bereichsweise befestigt ist und in anderen Bereichen lose zum Handhabungselement angeordnet ist.

Dies hat den besonderen erfindungsgemäßen Vorteil, dass eine Handhabungsvorrichtung mit einer derart angeordneten Adhäsionsfolie auf besonders einfache und leichte Art und Weise von der Oberfläche eines handzuhabenden Gegenstandes entfernt werden kann. Selbst wenn die Oberfläche der Adhäsionsfolie vollständig glatt und in der Ebene der planen Oberfläche des Gegenstandes an diesem anliegt, müssen zum Entfernen der Handhabungsvorrichtung von dem Gegenstand lediglich sehr geringe Kräfte aufgebracht werden, da durch die bereichsweise feste Anordnung und bereichsweise lose Anordnung der Adhäsionsfolie bei einem Bewegen der Handhabungsvorrichtung senkrecht zur Oberfläche, d.h. in Richtung von deren Normalen, die Adhäsionsfolie unter fortschreitender Verkleinerung der ursprünglichen Kontaktfläche von der Oberfläche des Gegenstandes abnehmbar ist, insbesondere abschälend abnehmbar ist.

Dabei ist es so, dass die Adhäsionsfolie zunächst in denjenigen Bereichen von der Oberfläche abgezogen wird, die an dem Handhabungselement fest angeordnet sind, wohingegen die gegenüber dem Handhabungselement lose angeordneten Bereiche an der Oberfläche des handzuhabenden Gegenstandes zunächst haften bleiben und sodann mit fortschreitender Entfernung des Handhabungselementes von der Oberfläche des Gegenstandes immer weiter von der Oberfläche des Gegenstandes unter fortschreitender Verkleinerung der Kontaktfläche abgezogen wird.

Somit wird sicher gestellt, dass eine Handhabungsvorrichtung der erfindungsgemäßen Art, nachdem sie eine sichere Wirkverbindung nach einem Anlegen an die Oberfläche des Gegenstandes erreicht hat, auf sanfte Art und Weise ohne ruckartiges Eintragen von Kräften in den Gegenstand von diesem abgezogen werden kann. Dies ist insbesondere wichtig bei sehr dünnen flächigen Gegenständen, wie beispielsweise Wafern oder sonstigen, die ansonsten durch Handhabungsvorrichtungen leicht zerstört werden können.

Die die Adhäsionsfolie ist mit einem außenliegenden Bereich (insbesondere mit Bezug auf Ihre Wirkoberfläche) im/am Handhabungselement befestigt und ist mit einem inneren Bereich der Adhäsionsfolie lose zum Handhabungselement.

So wird sich die Adhäsionsfolie bei einem Wegbewegen des Handhabungselementes von der Oberfläche des Gegenstandes von außen nach innen unter fortschreitender Verkleinerung des Kontaktes von der Oberfläche abgenommen, insbesondere abschälend abgenommen. So kann gerade durch den Effekt des Abschälens die Haftkraft senkrecht zur Oberfläche des handzuhabenden Gegenstandes minimiert werden, wohingegen jedoch eine sehr große Haftung innerhalb der Ebene der Oberfläche des Gegenstandes aufgrund der vollflächigen Anlage der Adhäsionsfolie an der Oberfläche dieses Gegenstandes erzielt wird.

Bei sämtlichen Ausführungsformen, insbesondere jedoch bei einer Ausführungsform, bei welcher die Adhäsionsfolie an einer Handhabungsvorrichtung in einer Ebene angeordnet ist, beispielsweise also an einer ebenen Oberfläche des Handhabungselementes angeordnet ist, kann diese Adhäsionsfolie perforiert sein.

Dies hat den Vorteil, dass beim Anlegen der Handhabungsvorrichtung bzw. der Adhäsionsfolie durch das Handhabungselement an eine plane Oberfläche eines Gegenstandes, die zwischen der Adhäsionsfolie und der Oberfläche dieses Gegenstandes befindliche Luft entweichen kann, wofür diese Luft entsprechende Wege in der Perforation der Adhäsionsfolie findet, die bevorzugt in Form von Kanälen in senkrechter Richtung zur Oberfläche der Adhäsionsfolie bzw. damit auch zur Oberfläche des Gegenstandes ausgeführt ist.

Bei einer Handhabungsvorrichtung der erfindungsgemäßen Art kann die Adhäsionsfolie eine Dicke aufweisen, so dass die Adhäsionsfolie selbst in sich stabil, gegebenenfalls auch selbsttragend ist ohne eine Stützung durch Hilfselemente zu erfordern. Es kann ebenso vorgesehen sein, dass die Adhäsionsfolie auf einem Trägerelement, insbesondere einer Trägerfolie angeordnet ist, die selbst keine Adhäsionseigenschaften aufweist.

Sofern im Rahmen dieser Erfindungsbeschreibung von speziellen Formgestaltungen oder Ausführungen der Adhäsionsfolie gesprochen wird, umfasst dies gleichermaßen eine entsprechende Ausführung oder Formgestaltung eines Trägerelementes, insbesondere einer Trägerfolie, auf welcher die Adhäsionsfolie zumindest teilbereichsweise, gegebenenfalls auch vollflächig angeordnet ist. Dabei kann es in einer Weiterbildung vorgesehen sein, dass eine Unebenheiten ausgleichende Schicht, z.B. Moosgummischicht zwischen Adhäsionsfolie und Trägerfolie oder direkt zwischen Adhäsionsfolie und Handhabungselement angeordnet ist, somit in jedem Fall eine rückseitige Druckbeaufschlagung der Adhäsionsfolie durch diese Schicht erfolgt.

In einer möglichen Ausgestaltung der Adhäsionsfolie kann es beispielsweise vorgesehen sein, dass diese eine Spiralform aufweist, wobei es sich grundsätzlich beispielsweise um eine einarmige Spirale handeln kann, insbesondere deren Äußeres an dem Handhabungselement befestigt ist und deren Spiralinneres lose zum Handhabungselement angeordnet ist, es ist jedoch bevorzugt vorgesehen, die Adhäsionsfolie als eine Spirale aus wenigstens zwei einander umgebenden Spiralarmen auszubilden, wobei es sodann vorgesehen sein kann, dass das jeweilige äußere Ende eines jeden Spiralarms am Handhabungselement, wie eingangs genannt, befestigt ist. Gerade die spiralförmige Ausgestaltung hat hierbei den Vorteil, dass bei einer vollflächigen Anlage der Adhäsionsfolie an der Oberfläche eines Gegenstandes eine hohe innere Steifigkeit der Adhäsionsfolie erzielt wird und somit in der Ebene eines handzuhabenden Gegenstandes große Kräfte übertragen werden können.

Sowohl bei der spiralförmig ausgestalteten Adhäsionsfolie als auch bei allen anderen Formgestaltungen, bei denen die Adhäsionsfolie von innen nach außen erstreckende Arme aufweist, kann es vorgesehen sein, dass die Arme dieser Adhäsionsfolie sich von innen nach außen verbreitern. Hierdurch wird die vorteilhafte Wirkung erzielt, dass dann, wenn die äußeren Bereiche der Arme fest an dem Handhabungselement angeordnet sind, sich beim Lösen der erfindungsgemäßen Handhabungsvorrichtung von der Oberfläche eines Gegenstandes zunächst relativ großflächige Bereiche von dieser Oberfläche lösen und sodann die pro Zeiteinheit von der Oberfläche sich lösenden Flächenbereiche kleiner werden, so dass sehr schnell eine Minimierung der verbleibenden Haftkraft erzielt wird, insbesondere bis dass zum Schluss lediglich der verbleibende innere Bereich der Adhäsionsfolie von der Oberfläche des Gegenstandes abgezogen wird. Darüber hinaus bietet die Verbreiterung der Arme nach außen hin den Vorteil, dass die Adhäsionsfolie bzw. deren Trägermaterial angreifenden Kräften, welche in den äußeren Bereichen am höchsten sind, leichter widerstehen kann.

Bei sämtlichen Ausführungsformen, insbesondere Formgestaltungen der Adhäsionsfolie bzw. einer eventuell vorgesehenen Trägerfolie mit einer daran angeordneten Adhäsionsfolie, kann es vorgesehen sein, dass das Handhabungselement als ein flächiger Körper ausgebildet ist, der von der Adhäsionsfolie oder von deren Trägerfolie überspannt ist.

Hierbei kann in einem Zustand, wenn eine erfindungsgemäße Handhabungsvorrichtung noch nicht an eine Oberfläche eines Gegenstandes zwecks Handhabung angelegt ist, die Adhäsionsfolie bzw. die Trägerfolie selbst in einer Ebene angeordnet sein, insbesondere in einer Ebene parallel zum flächigen Körper des Handhabungselementes, wobei es insbesondere auch vorgesehen sein kann, dass die Adhäsionsfolie oder die Trägerfolie den flächigen Körper kontaktiert.

In einer solchen Ausführungsform wird bevorzugt, wie es eingangs genannt ist, die Adhäsionsfolie und gegebenenfalls eine Trägerfolie eine Perforation zum Zweck der Luftverdrängung beim Anlegen an einen Gegenstand aufweisen.

In einer anderen Ausführungsform, die mit sämtlichen eingangs genannten bzw. auch später beschriebenen Formgestaltungen der Adhäsionsfolie und/oder einer Trägerfolie für diese kombinierbar ist, kann es auch vorgesehen sein, dass die Adhäsionsfolie von dem Handhabungselement mit einer Wölbung, insbesondere einer zumindest eindimensionalen Wölbung nach außen vorsteht. Dies ergibt eine Ausführungsform, bei der die Adhäsionsfolie oder eine Trägerfolie, welche eine solche Adhäsionsfolie zumindest teilweise trägt, ein Handhabungselement mit einer Wölbung, insbesondere einer zumindest eindimensionalen Wölbung, überspannt. Dabei kann es bevorzugt vorgesehen sein, dass die Wölbung derart ausgebildet ist, dass sich eine konvexe Seite der Adhäsionsfolie ausbildet, die einem handzuhabenden Gegenstand bzw. dessen planer Oberfläche zugewandt ist. Dementsprechend ist das Handhabungselement auf der konkaven Seite dieser Wölbung angeordnet und kann bevorzugt die Adhäsionsfolie von hinten zumindest in einem an die Oberfläche eines Gegenstandes angelegten Zustand stützen.

Die genannte Ausführungsform, bei welcher die Adhäsionsfolie bzw. eine diese tragende Trägerfolie eine zumindest eindimensionale Wölbung aufweist, hat den besonderen Vorteil, dass die Adhäsionsfolie mit dem Handhabungselement an die Oberfläche eines Gegenstandes unter fortschreitender Vergrößerung der Kontaktfläche anlegbar ist, insbesondere abrollend anlegbar ist.

So wird hierdurch erzielt, dass die Adhäsionsfolie bei einer Bewegung des Handhabungselementes auf die plane Oberfläche eines Gegenstandes zu, insbesondere in einer Richtung senkrecht zur Oberfläche, die Adhäsionsfolie zunächst die Oberfläche des Gegenstandes mit demjenigen Bereich kontaktiert, der den weitesten Abstand vom Handhabungselement aufweist. Die Adhäsionsfolie wird sich mit diesem Bereich (insbesondere inneren Flächenbereich) an die Oberfläche anlegen, wobei sich sodann durch das weitere Heranbewegen der Handhabungsvorrichtung an den Gegenstand die Kontaktfläche zwischen Adhäsionsfolie und der Oberfläche des Gegenstandes fortschreitend vergrößert und hierbei automatisch die zwischen Adhäsionsfolie und Oberfläche des Gegenstandes befindliche Luft verdrängt wird. Bei einer solchen Ausführung, bei der eine Wölbung der Adhäsionsfolie bzw. deren Trägerfolie vorgesehen ist, kann demnach eine eingangs genannte Perforation der Adhäsionsfolie oder Trägerfolie entfallen.

Der Vorteil einer gewölbten Ausführungsform ist dabei weiterhin der, dass eine Handhabungsvorrichtung der erfindungsgemäßen Art einer solchen Ausführung besonders schnell an die Oberfläche eines handzuhabenden Gegenstandes angelegt werden kann, ohne dass das Risiko besteht, dass sich ein Luftpolster zwischen den einander gegenüberstehenden Oberflächen von Adhäsionsfolie und Gegenstand ausbildet und somit ein Effekt des Schwimmens der Handhabungsvorrichtung über dem Gegenstand entstehen kann.

Die eingangs genannte Wölbung, die zumindest in einer Dimension ausgebildet ist, kann beispielsweise erzeugt sein dadurch, dass eine Unterstützung des inneren Bereichs der Adhäsionsfolie mittels eines Stützelementes vorgesehen ist. Ein solches Stützelement kann z.B. relativ zum Handhabungselement zurückweichen, wenn sich die Adhäsionsfolie plan an der Oberfläche des Gegenstandes anlegt. Ein Stützelement kann z.B. als ein Federelement, insbesondere eine Druckfeder ausgebildet sein.

Das Stützelement kann allgemein, unabhängig von seiner konkreten Ausbildung im / am Handhabungselement geführt, z.B. in einer Linearführung angeordnet sein.

Auch kann die Wölbung dadurch erzielt werden, dass von außen eine stauchende Kraft auf die Adhäsionsfolie bzw. eine diese tragende Trägerfolie einwirkt, die zu einem Ausbauchen der entsprechenden Folie führt. Eine solche stauchende Kraft kann beispielsweise dadurch erzielt werden, dass die äußeren Befestigungspunkte für die Adhäsionsfolie bzw. deren Trägerfolie an dem Handhabungselement einen geringeren Abstand aufweisen als der Abstand der Befestigungspunkte auf einer eben ausgebreiteten Adhäsionsfolie bzw. Trägerfolie.

Bei sämtlichen eingangs genannten Ausführungsformen kann es vorgesehen sein, dass das Handhabungselement als flächiger Körper mit einer grundsätzlich beliebigen Grundform, z.B. runden oder ovalen oder mit einer (mehr-)eckigen Grundform ausgebildet ist, insbesondere mit einer geraden Anzahl von Ecken ausgebildet ist, wobei die Adhäsionsfolie bzw. die Trägerfolie derselben im Bereich der Kanten, insbesondere im Bereich von wenigstens zwei, insbesondere einander gegenüberliegenden Kanten des Körpers an oder auch in diesem befestigt ist. Dabei kann wie eingangs genannt diese Befestigung sowohl starr als auch besonders bevorzugt beweglich ausgeführt sein. Insbesondere kann es vorgesehen sein, bei einer Anzahl von mehr als drei Ecken bzw. damit auch Kanten des Körpers, dass bei einer Befestigung der Adhäsions- bzw. Trägerfolie an dem Handhabungselement eine wenigstens zweidimensionale Wölbung erzielt wird.

Dabei ist darauf hinzuweisen, dass unter einer eckigen Grundform eines flächigen Körpers auch eine solche Form verstanden wird, bei der die Kanten des Körpers stetig ineinander übergehen, somit also im Wesentlichen die Ecken gerundet ausgebildet sind. Der Begriff einer Ecke im Sinne der Erfindung ist damit nicht in seinem strengen Wortlaut zu verstehen.

Eine Ausführungsform, bei der eine Adhäsionsfolie mit einer Wölbung, zumindest einer ein-, bevorzugt wenigstens zweidimensionalen Wölbung, den flächigen Körper eines Handhabungselementes überspannt, wird demnach bevorzugt die Adhäsionsfolie oder eine diese tragende Trägerfolie zur Oberfläche des flächigen Körpers, die dem Gegenstand zugewiesen ist, zumindest größtenteils, gegebenenfalls vollständig anlagefrei sein, insbesondere ausgenommen im Bereich der Kanten oder an einem Stützelement, das sich zwischen der Adhäsionsfolie / der Trägerfolie und dem Handhabungselement erstreckt. Dabei kann es vorgesehen sein, dass die Adhäsionsfolie bzw. Trägerfolie im Bereich der Kanten an der Oberfläche des flächigen Körpers, z.B. an der Oberfläche der Unterseite befestigt ist oder aber auch in einer anderen Ausführungsform an/in den Stirnseiten dieser Kanten.

Eine symmetrische und vorteilhafte Ausführungsform ergibt sich insbesondere, wenn die den flächigen Körper überspannende Adhäsionsfolie bzw. Trägerfolie dieser Adhäsionsfolie, ausgehend von einem zusammenhängenden mittleren Bereich, eine der Anzahl der Kanten des Körpers entsprechende Anzahl von Armen aufweist, die sich in die Richtung der Kanten erstrecken. Die Ausbildung von Armen, die vom inneren oder auch mittleren Bereich einer Adhäsionsfolie ausgehen, können beispielsweise dadurch erzeugt sein, dass die Adhäsionsfolie, ausgehend von einem mittleren, inneren Bereich Schlitze aufweist, die in die Richtung der Ecken des flächigen Körpers verlaufen, an welchem die Adhäsionsfolie bzw. die Trägerfolie angeordnet ist. Hierbei kann es insbesondere, wie bereits eingangs genannt, vorgesehen sein, dass sich die Arme von innen nach außen verbreitern.

Für eine Befestigung insbesondere der äußeren Enden der jeweiligen Arme kann es hier vorgesehen sein, dass die Adhäsions- und/oder Trägerfolie am äußeren Ende der Arme jeweilige lappenförmige Endbereiche aufweist, die jeweils zumindest um die jeweilige Kante der Oberfläche (die dem Gegenstand zugewiesen ist, ggfs auch um die Kante der Unterfläche des Körpers des Handhabungselementes herumgeführt, z.B. gelenkig herumgeführt oder auch herumgebogen sind und im Bereich der Kante, hier bevorzugt an der Kantenstirnseite des Körpers oder an der kantennahen Unterfläche des Körpers, mit diesem insbesondere beweglich verbunden sind.

Gerade durch eine bewegliche Verbindung der äußeren Enden der Arme, die bei jeder der vorgenannten Ausführungsformen vorgesehen sein kann, wird vorteilhaft erzielt, dass bei einem Abflachen der ursprünglichen Wölbung beim Vorgang des Anlegens der erfindungsgemäßen Handhabungsvorrichtung an die Oberfläche eines Gegenstandes, die beim Anlegen der Adhäsionsfolie auf die Oberfläche entstehenden Kräfte, die die äußeren Enden weiter nach außen drücken, abgefangen werden können, sodass die Folie ungehindert ausgebreitet werden kann.

Die jeweils äußeren Bereiche der Adhäsionsfolie bzw. deren Trägerfolie bzw. bevorzugt die lappenförmige Enden können am Endbereich z.B. jeweils zwei Gelenke bzw. Scharniere mit parallelen Achsen aufweisen, deren Drehachsen weiterhin auch parallel zur jeweiligen Kante (oberen und/oder unteren) des Körpers des Handhabungselementes verlaufen. Bevorzugt ist ein Gelenk /Scharnier auf der Höhe der oberen Kante und ein Gelenk / Scharnier auf der Höhe der unteren Kante des Körpers angeordnet. Zwischen den Scharnieren / Gelenken ergibt sich demnach ein Lappenbereich der parallel zur Stirnseite des Körpers verläuft und der verstärkt, z.B. CFK / GFK-verstärkt, ausgebildet sein kann, um ein internes Knicken oder Wölben zu vermeiden.

Der äußerste Lappenbereich jenseits des letzten Scharniers / Gelenkes kann bevorzugt an der Unterfläche, insbesondere kantennah am Körper befestigt sein.

Beide letztgenannten Lappenbereiche müssen nicht unbedingt eine Adhäsionsfolie tragen, da diese Bereiche nicht auf einen zu greifenden Gegenstand weisen. Es kann sich um Bereiche handeln, die lediglich tragende Funktion oder Befestigungsfunktion haben, jedoch keine greifende Funktion. Insofern können diese lappenförmigen Bereiche auch als zur Adhäsionsfolie /Trägerfolie separate Elemente ausgebildet sein, die untereinander und/oder mit der Adhäsionsfolie / Trägerfolie durch die Gelenke / Scharniere verbunden sind.

Ein Gelenk bzw. Scharnier kann z.B. als eine Materialverdünnung in der Adhäsionsfolie bzw. deren Trägerfolie ausgebildet sein. Ein Gelenk / Scharnier kann auch dadurch ausgebildet sein, dass zwei Lappenbereiche mit einem flexiblen Material, z.B. mit einem textilen Gewebe oder mit einer knickbaren Folie hinterlegt sind. Dies ist besonders dann bevorzugt, wenn die lappenförmigen Bereiche als separate Elemente ausgebildet sind, die mit der Adhäsionsfolie /Trägerfolie verbunden sind.

Es kann hier insbesondere vorgesehen sein, dass die lappenförmigen Enden der Arme von Adhäsions- bzw. Trägerfolie bzw. auch die ggfs. separaten zuvor genannten Elemente alle untereinander mittels einer Hebel- und/oder Getriebemechanik verbunden sind, mittels der auf alle Enden gleichzeitig die gleiche Schub- oder Zugkraft ausübbar ist. So wird bewirkt, dass sich die Wölbung beim Anlegen einer erfindungsgemäßen Vorrichtung an die Oberfläche eines handzuhabenden Gegenstandes symmetrisch abbaut, da selbst dann, wenn eine Kraft beim Prozess des Anlegens ursprünglich stärker bezüglich eines der Arme wirkt, durch die Hebel- bzw. Getriebemechanik bewirkt wird, dass diese Kraft gleichmäßig auf alle Arme verteilt wird.

Hierfür kann es vorgesehen sein, dass die Hebel- und/oder Getriebemechanik im Inneren des Handhabungselementes angeordnet ist und die lappenförmigen Enden durch Schlitze in den seitlichen Stirnseiten (senkrecht zur Oberfläche die dem Gegenstand zugewiesen ist) in das Innere des Handhabungselementes eingeführt und mit dieser Mechanik verbunden sind. Beispielsweise kann dafür ein Handhabungselement aus einem Oberteil und einem Unterteil aufgebaut sein, zwischen denen die Hebel- und Getriebemechanik angeordnet ist, wobei über die eingangs genannten Schlitze in den Stirnseiten die lappenförmigen Enden der Arme der Adhäsions- bzw. Trägerfolie in den Bereich der Trennebene zwischen Ober- und Unterteil eingeführt sind. Die lappenförmigen Enden sind dafür umgebogen in eine Ebene parallel zur Oberfläche des Handhabungselementes, welche zum Gegenstand weist, bzw. parallel zu dessen Oberfläche.

Die Getriebemechanik bzw. Hebelmechanik kann in einer beispielhaften Ausführungsform so realisiert sein, dass zwei koaxial auf einer Achse übereinanderliegende Drehkreuze vorgesehen sind, wobei die in zwei verschiedenen Ebenen übereinandergeordneten Drehkreuze an ihren radial außen liegenden Endbereichen jeweils einen gelenkig angeordneten Hebel aufweisen und die äußeren Enden von zwei Hebeln der übereinanderliegenden Drehkreuze eine gemeinsame Anlenkstelle ausbilden, an der das lappenförmige Ende eines jeweiligen Armes der Adhäsions- bzw. Trägerfolie befestigt ist.

Bei allen Ausführungsformen kann es vorgesehen sein, dass insbesondere in dem Zustand, wenn die Adhäsionsfolie an einen Gegenstand plan angelegt ist, die plan gelegte Adhäsionsfolie in diesem planen Zustand arretierbar ist, z.B. mittels einer Wirkverbindung zwischen der Adhäsionsfolie und/oder der Trägerfolie und dem Handhabungselement bzw. dessen Körper.

In einer möglichen Ausführung kann es dafür vorgesehen sein, dass durch Kanäle, die durch das Handhabungselement führen ein Unterdruck / Vakuum in den Bereich der Oberfläche des Handhabungselementes geführt ist / führbar ist, die der Unterfläche der Adhäsionsfolie bzw. deren Trägerfolie zugewiesen ist. So kann durch den wirkenden Unterdruck die Adhäsionsfolie in einer festen Anlage zur Oberfläche des Handhabungselementes gehalten werden. Die Kanäle können schaltbar mit einer Vorrichtung zur Erzeugung eines Unterdrucks / Vakuum verbunden sein, z.B. mit einer Pumpe.

Auch kann eine magnetische Wirkverbindung vorgesehen sein, z.B. dadurch dass die Adhäsionsfolie und/oder Trägerfolie magnetische Partikel umfasst oder eine magnetische Folie an der Adhäsions- oder Trägerfolie befestigt ist, z.B. unter oder zwischen diesen. Durch eine Magnetvorrichtung innerhalb des Handhabungselementes kann schaltbar die Adhäsionsfolie / Trägerfolie in der planen Lage gehalten werden durch anziehende magnetische Kräfte. Z.B. kann die Magnetvorrichtung als wenigstens ein schaltbar bestrombarer Elektromagnet ausgeführt sein. Ebenso kann alternativ wenigstens ein schaltbar positionsveränderbarer Permanentmagnet in dem Handhabungselement vorgesehen sein.

In einer davon unabhängigen, jedoch auch mit den vorherigen Ausführungen kombinierbaren Weiterbildung kann es vorgesehen sein, dass die Adhäsionsfolie und/oder Trägerfolie gas- / luftdurchlässig (permeabel) ist bzw. in die Oberfläche mündende Kanäle / Öffnungen aufweist, insbesondere die Ober- und Unterseite von Adhäsions- bzw. Trägerfolie verbinden. Ein an das Handhabungselement angelegtes Vakuum bzw. ein Unterdruck, der an der Oberfläche des Handhabungselementes erzeugbar ist, welche der Unterfläche der Adhäsionsfolie / Trägerfolie zugewiesen ist, kann bei dieser Ausführung auch durch die Adhäsionsfolie / Trägerfolie hindurch auf den zu haltenden Gegenstand wirken.

Neben den Adhäsionskräften, die hauptsächlich parallel zur Oberfläche des gegriffenen Gegenstandes wirken, können so auch senkrecht dazu wirkende Kräfte, insbesondere Hebekräfte aufgebracht werden. Auch hier kann der Unterdruck durch Kanäle im Handhabungselement an dessen Oberfläche angelegt sein. Die Kanäle die in die Oberfläche des Handhabungselementes münden, können z.B. zumindest teilweise mit Kanälen fluchten, die durch die Adhäsionsfolie / Trägerfolie bzw. das Sandwich aus beiden hindurchführen.

Ebenso besteht die Möglichkeit eine erfindungsgemäße Handhabungsvorrichtung in Kombination mit wenigstens einem Unterdruckgreifer anzuordnen, z.B. in einer Nebeneinander- oder Umeinanderanordnung, insbesondere um so mit beiden Arten der Greiftechnik sowohl Kräfte parallel als auch senkrecht zur Oberfläche des gegriffenen Gegenstandes aufzubringen.

Das Grundprinzip der Erfindung sowie bevorzugte Ausführungen sind in den nachfolgenden Figuren dargestellt. Es zeigen:
- Figur 1: das Anlegen einer gewölbten Adhäsionsfolie an einen Gegenstand kurz vor der Kontaktierung zwischen Adhäsionsfolie und Oberfläche
- Figur 2: den Anlegvorgang unter fortschreitender Vergrößerung der Kontaktfläche
- Figur 3: die Manipulationsmöglichkeit des Gegenstandes mit einer angelegten Handhabungsvorrichtung
- Figur 4: das Entfernen einer Handhabungsvorrichtung vom Gegenstand
- Figur 5: eine perspektivische Ansicht einer bevorzugten Ausführungsform einer erfindungsgemäßen Handhabungsvorrichtung
- Figur 6: eine Getriebe-/Hebelvorrichtung zur gleichmäßigen Kraftbeaufschlagung der Adhäsionsfolie
- Figur 7: eine alternative Ausführungsform mit spiralförmiger Anordnung der Adhäsionsfolie
- Figur 8: eine weitere Alternative einer spiralförmig ausgebildeten Adhäsionsfolie
- Figur 9: eine Prinzipdarstellung einer Ausführungsvarianten mit Gelenken /Scharnieren in planer Anlage beim Greifen eines Gegenstandes
- Figur 10: eine Prinzipdarstellung einer Ausführungsvarianten mit Gelenken /Scharnieren im gewölbten Zustand
- Figur 11: eine konkrete Ausführung gemäß Figuren 9 und 10
- Figur 12: eine Schnittdarstellung der Figur 11

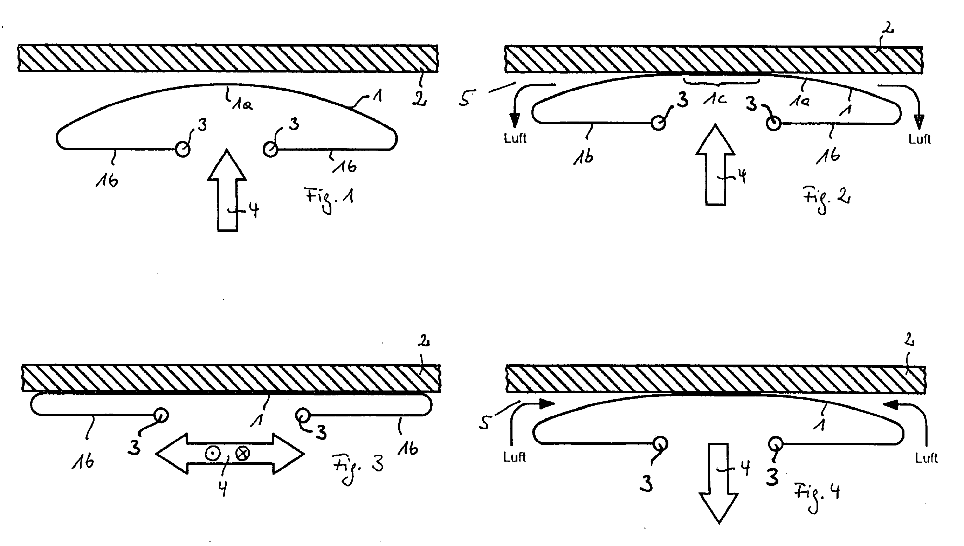

Die Figur 1 zeigt in schematischer Darstellung das Grundprinzip einer erfindungsgemäßen Handhabungsvorrichtung, wobei hier eine Ausführungsform dargestellt ist, bei der eine Adhäsionsfolie 1 gegenüber einem nicht dargestellten Handhabungselement eine gewölbte Form aufweist in dem Zustand, wenn die erfindungsgemäße Vorrichtung noch nicht an die plane Oberfläche eines handzuhabenden Gegenstandes 2 angelegt ist. Die Adhäsionsfolie 1 bzw. alternativ eine Trägerfolie, auf welcher die Adhäsionsfolie zumindest teilweise angeordnet ist, ist hier an Punkten 3 mit einem nicht dargestellten Handhabungselement verbunden bzw. an diesem befestigt, wobei es hier vorgesehen sein kann, dass die relative Lage der Befestigungspunkte 3 zueinander nicht fix, sondern variabel ist.

Dabei kann es, wie im allgemeinen Teil der Beschreibung formuliert ist, vorgesehen sein, dass der gewölbte, konvexe Teil 1 a der Adhäsions- bzw. Trägerfolie das hier nicht dargestellte Handhabungselement bzw. deren Oberfläche überspannt, das Handhabungselement demnach im konkaven Bereich angeordnet ist, wobei die ungewölbten Folienbereiche 1b beispielsweise ebenso wie die Befestigungspunkte 3 im Inneren des Handhabungselementes angeordnet sind. Dies ist jedoch nicht zwingend, eine Befestigung bzw. Lage der Punkte 3 kann grundsätzlich an jedem Ort eines Handhabungselementes vorgesehen sein. Die Figur 1 zeigt hier eine Bewegung der erfindungsgemäßen Vorrichtung in Richtung des Pfeils 4, d.h. hier im Wesentlichen senkrecht zur Oberfläche des Gegenstandes 2, so dass die dargestellte Situation die erfindungsgemäße Handhabungsvorrichtung kurz vor einem Erstkontakt mit der Oberfläche des Gegenstandes 2 zeigt. Diese Situation kann beispielsweise das Anheben einer erfindungsgemäßen Handhabungsvorrichtung von unten an die untere Oberfläche eines Gegenstandes 2 darstellen.

Die Figur 2 zeigt, dass der gewölbte Teil 1 a der Adhäsionsfolie 1 bzw. einer Trägerfolie zunächst mit einem inneren Bereich der Fläche des Adhäsionsfolie 1 den Gegenstand 2 kontaktiert und die Luft aus dem Zwischenbereich 5 zwischen Adhäsionsfolie und Oberfläche des Gegenstandes 2 verdrängt wird unter fortschreitender Vergrößerung der Kontaktfläche zwischen Adhäsionsfolie 1 und Gegenstand 2. Dabei rollt / wälzt sich die Adhäsionsfolie 1 auf der Oberfläche des Gegenstandes 2 ab.

Die Figur 3 zeigt die Situation, wenn die erfindungsgemäße Handhabungsvorrichtung maximal an den Gegenstand 2 angelegt ist. In diesem Zustand kann eine weitere Vergrößerung der Kontaktfläche zwischen Adhäsionsfolie und Oberfläche des Gegenstandes 2 nicht mehr stattfinden, wobei eine Situation erreicht werden kann, bei welcher nicht nur die Adhäsionsfolie 1 plan an der Oberfläche des Gegenstandes 2 anliegt, sondern auch plan an der Oberfläche eines nicht dargestellten Handhabungselementes, so dass dieses Handhabungselement die Adhäsionsfolie von hinten stützt bzw. die Adhäsionsfolie zwischen Handhabungselement und Oberfläche des Gegenstandes 2 angeordnet ist. Hier - wie auch den anderen Figuren - ist auch erkennbar, dass die Enden 1 b der Adhäsionsfolie, die insbesondere die eingangsgenannten Lappen an den Armen ausbilden können umgebogen sind und parallel zur Ebene der Oberfläche des Gegenstandes 2 liegen.

In der hier dargestellten Situation der Figur 3 ist bei der maximal möglichen Kontaktfläche zwischen Adhäsionsfolie und Oberfläche des Gegenstandes 2 auch die Wirkverbindung zwischen der erfindungsgemäßen Handhabungsvorrichtung und dem Gegenstand 2 maximal aufgrund der beispielsweise wirkenden Van der Waals-Kräfte oder der Kontaktierung der Nanostrukturierungen von Folienoberfläche und Gegenstandsoberfläche. Es kann sodann eine Manipulation bzw. Handhabung und hier insbesondere Bewegung des handzuhabenden Gegenstandes 2 parallel zur bzw. in der Ebene des Gegenstandes 2 erfolgen, wie es hier wiederum durch die Pfeile 4 dargestellt ist. In dieser Situation kann beispielsweise das Bewegen des Gegenstandes 2 mittels einer in der Ebene verfahrbaren Transportvorrichtung, beispielsweise eines Zylinder- oder vergleichbaren Linearantriebs, erfolgen.

Die Figur 4 zeigt im Wesentlichen den umgekehrten Fall zur Figur 2, nämlich das Entfernen der Handhabungsvorrichtung erfindungsgemäßer Art vom Gegenstand 2. Hier ist ersichtlich, dass sich die äußeren Bereiche der Adhäsionsfolie 1 durch das Wegbewegen der Handhabungsvorrichtung in Richtung des Pfeils 4 zunächst von der Oberfläche des Gegenstandes 2 lösen und somit wiederum Luft in den Zwischenraum 5 eintreten kann. Die Kontaktfläche zwischen Adhäsionsfolie 1 und Oberfläche des Gegenstandes 2 verringert sich somit zunehmend, so dass die Wirkverbindung zwischen erfindungsgemäßer Handhabungsvorrichtung und Gegenstand 2 sukzessive abgebaut wird.

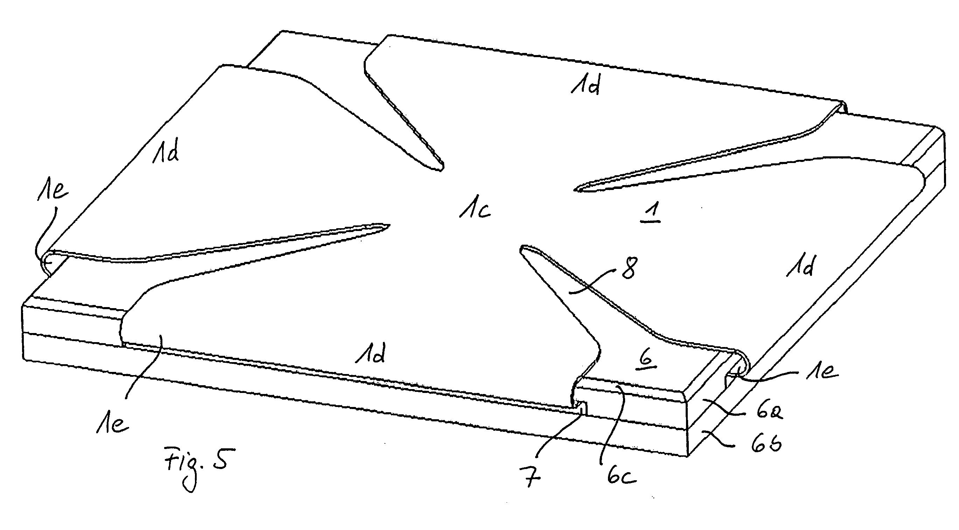

Die Figur 5 zeigt eine perspektivische Ansicht einer erfindungsgemäßen Handhabungsvorrichtung, bei welcher die Adhäsionsfolie 1 bzw. eine Trägerfolie, an welcher die Adhäsionsfolie zumindest teilweise befestigt ist, mit einer hier im Wesentlichen nicht erkennbaren jedoch vorliegenden Wölbung, die Oberfläche 6 eines aus zwei Teilen 6a und 6b umfassenden Handhabungselementes überspannt. Dabei bildet die Adhäsionsfolie 1 einen inneren bzw. mittigen Bereich 1c, von dem aus sich nach außen jeweilige nach außen verbreiternde Arme 1d erstrecken. Das Handhabungselement ist hier im Querschnitt (parallel zur Oberfläche des Gegenstandes) viereckig ausgebildet, so dass auch insgesamt vier Arme 1 d bei der Adhäsionsfolie vorgesehen sind, die sich vom mittleren Bereich 1 c in Richtung der jeweiligen Kante 6c des Handhabungselementes erstrecken, wobei die äußeren Enden der Arme 1d Laschen 1e bilden, die um die Kanten 6c herumgebogen sind und durch einen jeweiligen Schlitz 7, der in der Trennebene zwischen Oberteil 6a und Unterteil 6b des Handhabungselementes angeordnet ist, in das Innere des Handhabungselementes eingreifen. Die hier dargestellte Formgestaltung der Adhäsionsfolie 1 kann beispielsweise erzielt werden, indem eine Fläche einer Adhäsionsfolie 1 mit Schlitzen 8 versehen wird, die von dem mittleren, zusammenhängenden Flächenbereich 1c sich in die Richtung der jeweiligen Ecken des Handhabungselementes erstrecken und in dieser bevorzugten Ausführungsform dabei verbreitern.

Durch die Befestigung der jeweiligen Laschen 1e im Inneren des Handhabungselementes bzw. zumindest bei anderen Ausführungsformen in einem äußeren Randbereich des Handhabungselementes kann erzielt werden, dass sich hier eine im Wesentlichen zweidimensionale Wölbung der Fläche der Adhäsionsfolie 1 ergibt, bei der eine jeweilige Wölbung sich über zwei einander gegenüberliegende Arme 1d einstellt.

Ersichtlich ist es, dass eine erfindungsgemäße Handhabungsvorrichtung gemäß der Figur 5 verwendet werden kann, wie es in den Figuren 1 und 4 dargestellt ist, wobei diese Figuren mit Bezug auf Figur 5 lediglich die Wölbung der Adhäsionsfolie 1 bzw. deren Trägerfolie in einer Dimension, also im Schnitt zwischen zwei gegenüberliegenden Folienarmen 1 d zeigt.

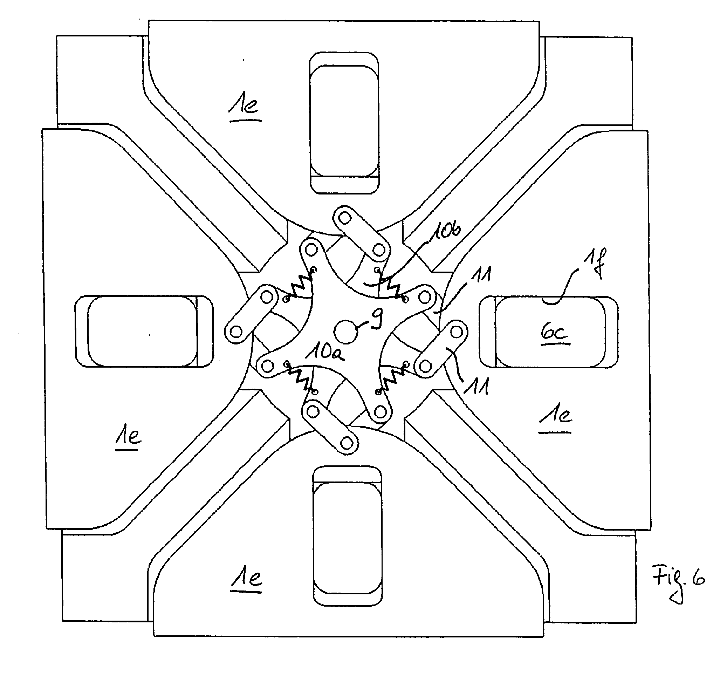

Die Figur 6 zeigt eine mögliche Ausgestaltung des inneren Aufbaus des Handhabungselementes sowie die Verbindung der jeweiligen Laschenenden 1 e der Arme 1 d der Adhäsionsfolie 1. Dargestellt ist hier im Inneren und somit im Wesentlichen in der Trennebene, in welcher ein jeweiliger Schlitz 7 angeordnet ist, wie die Laschen 1e über einen Getriebe- bzw. Hebelmechanismus untereinander im Inneren des Handhabungselementes verbunden sind. Der Mechanismus weist hier eine gemeinsame Drehachse 9 auf, zu der koaxial zwei Drehkreuze 10a und 10b parallel zur Trennebene angeordnet sind, wobei die Drehkreuze eine Anzahl von Armen jeweils aufweisen, die der Anzahl der Laschen 1e entsprechen. Jeder Arm eines Drehkreuzes weist dabei an seinem radialen äußeren Ende einen gelenkig verbundenen Hebel 11 auf, wobei das jeweilige äußere Ende eines solchen Hebels 11 eines der beiden Drehkreuze mit dem äußeren Ende des Hebels 11 des anderen Drehkreuzes gelenkig verbunden ist und diese gelenkige Verbindungsstelle eine Befestigungsstelle einer Lasche 1e bildet.

Wird demnach eine Lasche 1e beim Anlegen der erfindungsgemäßen Handhabungsvorrichtung an die Oberfläche eines Gegenstandes durch den Abbau der Wölbung aus dem Handhabungselement herausgezogen, so zieht diese Lasche über die beiden Hebel 11 zwei korrespondierende Arme des jeweiligen Drehkreuzes 10a und 10b aufeinander zu. Aufgrund der Anordnung der Drehkreuze auf einer gemeinsamen Achse erfolgt dies unabhängig davon, von welcher Lasche 1e die Zugkraft ausgeht, immer gleichzeitig bezüglich aller, durch die Mechanik miteinander verbundenen Laschen 1e, so dass die Kraftentfaltung innerhalb der Adhäsionsfolie 1 immer gleichmäßig ist und sich die Adhäsionsfolie 1 grundsätzlich gleichmäßig und faltenfrei ohne jegliche Lufteinschlüsse an die plane Oberfläche eines Gegenstandes 2 anlegen kann.

Die Figur 6 zeigt hier weiterhin, dass die Laschen 1e jeweils schlitzförmige Ausnehmungen 1f aufweisen können, mit denen eine Lasche 1e ein vorspringendes Element 6c entweder vom Oberteil 6a oder Unterteil 6b des Handhabungselementes umgreift, so dass die Laschen 1e eine Führung aufweisen.

Ersichtlich ist die Erfindung bezüglich dieser Ausführungsform nicht auf die Formgestaltung der Adhäsionsfolie beschränkt, wie sie die Figur 5 zeigt. Selbstverständlich ist es möglich, eine höhere oder auch geringere Anzahl von Armen 1d vorzusehen und beispielsweise das Handhabungselement 6 nicht nur viereckig, sondern auch drei-, fünf-, sechs- oder allgemein mehreckig auszuführen. Dabei ist die Anzahl der Arme / Laschen bevorzugt an die Anzahl der Ecken bzw. Kanten des Handhabungselementes 6 angepasst.

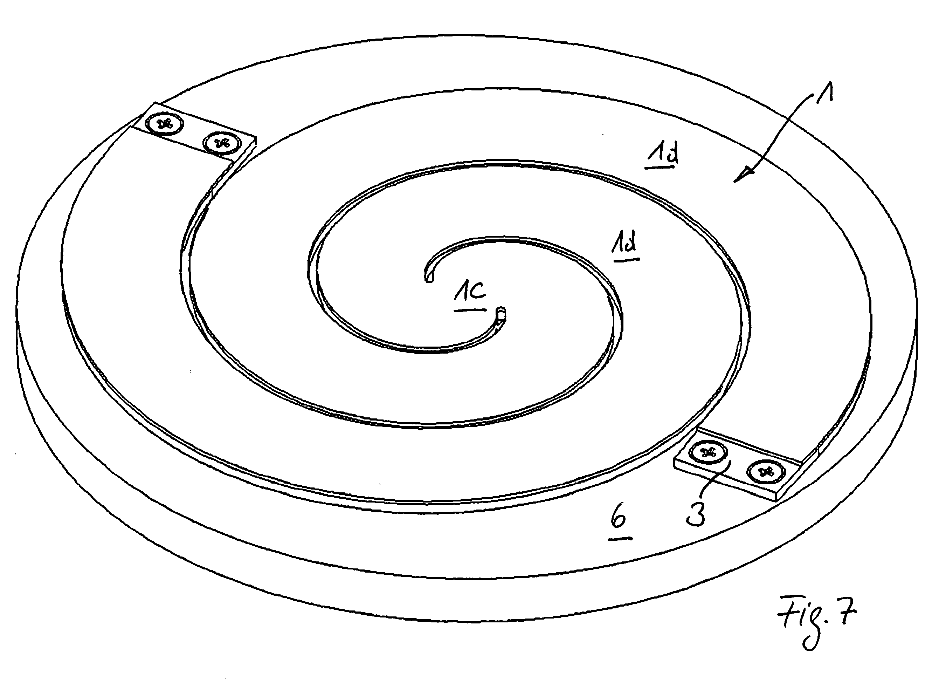

Die Figur 7 zeigt eine alternative Ausführungsform mit einem Handhabungselement 6, welches eine plane Oberfläche aufweist, wobei hier die Adhäsionsfolie 1 eine Formgestaltung aufweist aus zwei spiralförmig einander umwindenden Spiralarmen, deren äußeren Enden an einer Befestigungsstelle 3 mit der Oberfläche des Handhabungselementes 6 verbunden sind.

Hier ist die Adhäsionsfolie 1 ohne eine Wölbung parallel zur Oberfläche 6 des Handhabungselementes und diese Oberfläche 6 kontaktierend angeordnet. Mittels des Handhabungselementes kann somit die Adhäsionsfolie 1 an die Oberfläche eines hier nicht gezeigten Gegenstandes angelegt werden, wobei Luft zwischen Adhäsionsfolie und Oberfläche des Gegenstandes zum einen zwischen den beiden spiralförmig einander umwindenden Armen entweichen kann und wobei weiterhin die Adhäsionsfolie 1 eine Perforation aufweisen kann, um ein Entweichen von Luft besser zu ermöglichen.

Ersichtlich ist die Ausführung hier dergestalt, dass zum Entfernen der erfindungsgemäßen Handhabungsvorrichtung von einem Gegenstand diese senkrecht zur Oberfläche abgezogen werden kann, wobei sich zunächst bei der Adhäsionsfolie 1 diejenigen Bereiche von der Oberfläche des Gegenstandes lösen, die an den Befestigungsstellen 3 am Handhabungselement befestigt sind. Es erfolgt dann ein Vorgang eines spiralförmigen Abschälens mit fortschreitender Verringerung der Kontaktfläche, bis dass zum Schluss auch der mittige Bereich 1 c der Adhäsionsfolie vom Gegenstand abgezogen ist.

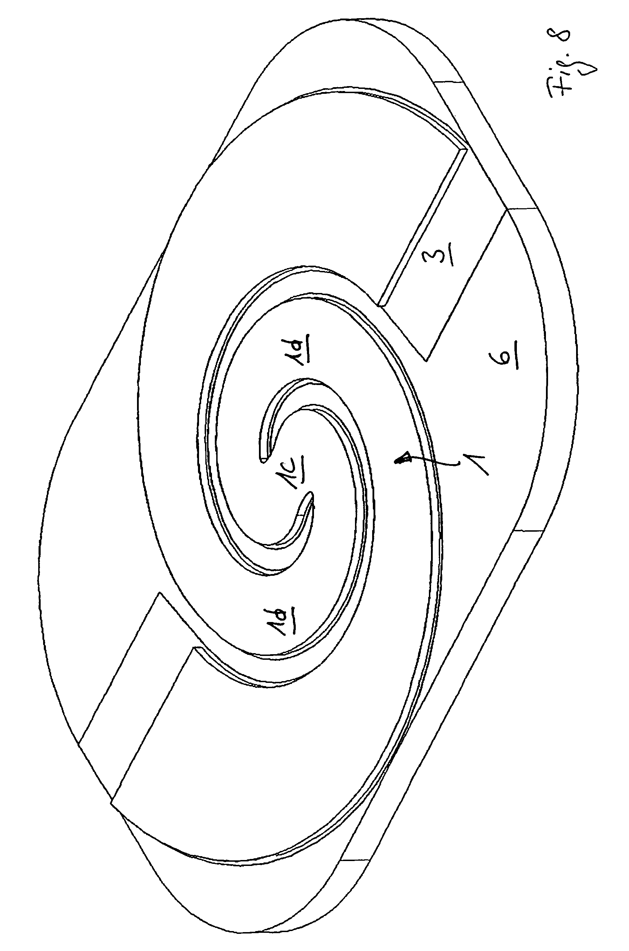

Die Figur 8 zeigt demgegenüber eine alternative Ausgestaltung, ebenfalls mit einer spiralförmigen Anordnung der Adhäsionsfolie 1 auf der Oberfläche 6 eines Handhabungselementes, wobei hier die beiden spiralförmig einander umwindenden Arme sich von innen nach außen verbreitern, so dass bei einem Abziehen der erfindungsgemäßen Handhabungsvorrichtung ein sehr schnelles Verringern der verbleibenden Kontaktfläche erzielt wird. Darüber hinaus wird durch diese Gestaltung die Steifigkeit der Folie gegenüber in der Ebene angreifenden Kräften erhöht. Auch hier ist die Ausführung ansonsten im Wesentlichen wie bei der Figur 7, d.h. die äußeren Enden der spiralförmigen Arme sind an Befestigungsstellen 3 mit der Oberfläche des Handhabungselementes 6 verbunden.

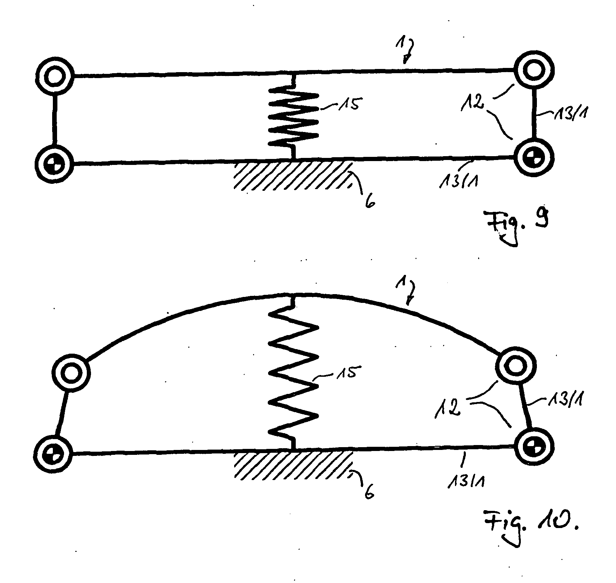

Figur 9 zeigt eine geschnittene Prinzipdarstellung, bei welcher symbolisiert dargestellt ist, dass an den äußeren Enden der Adhäsionsfolie 1 bzw. an den Enden der Arme zwei Gelenke 12 angeordnet sind, die in dieser Darstellung parallele Drehachsen senkrecht zur Papierebene aufweisen. Allgemein gilt bei dieser Ausführung, dass das untere dem Körper 6 des Handhabungselementes zugewiesene Gelenk 12 dabei ortsfest zum Körper ist.

Im Vergleich mit der Figur 10 ist erkennbar, dass das obere Gelenk / Scharnier 12 sich gegenüber dem unteren bzw. gegenüber dem Körper 6 bewegen kann. Eine durch das Planlegen bzw. durch eine Wölbung entstehende Bewegung der äußeren Enden der Adhäsionsfolie 1 bzw. der Trägerfolie kann somit abgefangen werden. Erkennbar ist hier auch, dass zwischen den Gelenken / Scharnieren und jenseits des unteren Gelenks / Scharniers 12 entweder die Adhäsionsfolie /Trägerfolie 1 weiter verläuft oder ein separates Element 13 vorgesehen ist. In dieser Ausführung ist auch der mittelere Bereich 1 c der Trägerfolie bzw. Adhäsionsfolie 1 unterstützt durch ein Stützelement 15.

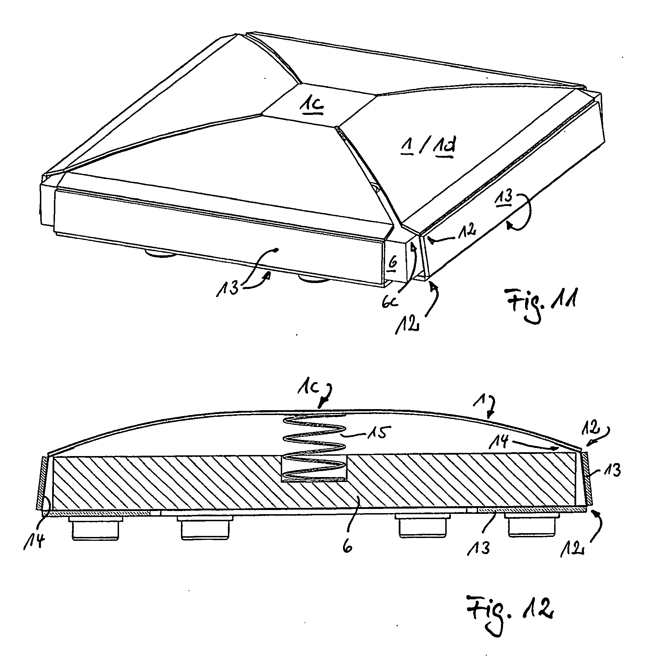

Die Figuren 11 und 12 zeigen in perspektivischer Ansicht bzw. Schnittansicht eine konkrete Ausführung des Prinzips nach Figuren 9 und 10.

Vom mittleren Bereich 1 c der Adhäsions-/Trägerfolie 1 aus erstrecken sich jeweils Arme 1d, in diesem Fall vier Arme, die auf die Kanten 6c des Körpers 6 zulaufen und sich dabei verbreitern. An den Enden dieser Arme sind jeweils die zwei Gelenke / Scharniere 12 angeordnet. Der oberhalb des Körpers 6 angeordnete Teil der Enden der Arme 1 d ist durch die Adhäsionsfolie bzw. Trägerfolie 1 selbst ausgebildet wohingegen der gegenüber den seitlichen Stirnflächen des Körpers 6 und unter dem Körper 6 liegende Teil der Enden der Arme 1d als separate Elemente 13 ausgebildet sind die untereinander und mit der Adhäsionsfolie /Trägerfolie 1 durch ein hinterlegtes flexibles Gewebe 14 oder eine flexible Folie 14 gelenkig in der Art eines Scharniers 12 verbunden sind. Die unteren Elemente 13 sind hier mit Schrauben an der Unterfläche des Körpers 6 fixiert.

Das Stützelement 15, welches hier als Schrauben- Druckfeder ausgebildet ist, ist weiterhin noch im Körper 6 in einer Ausnehmung geführt und greift von Innen an dem mittleren Bereich 1 c der Adhäsionsfolie / Trägerfolie an, um diese aufzuwölben.

## Patentansprüche

1. Handhabungsvorrichtung für Gegenstände mit planen, insbesondere glatten Oberflächen, die ein Handhabungselement (6) umfasst, an welchem eine Adhäsionsfolie (1) bereichsweise befestigt (3) und bereichsweise lose angeordnet ist, so dass die Adhäsionsfolie (1) durch eine Bewegung des Handhabungselementes (6) senkrecht zu der Oberfläche des Gegenstandes (2) unter fortschreitender Verkleinerung der Kontaktfläche von der Oberfläche eines Gegenstandes (2) abnehmbar ist, **dadurch gekennzeichnet, dass** die Adhäsionsfolie (1) einen inneren Bereich (1 c) aufweist, der zum Handhabungselement (6) lose ist und von dem sich die Adhäsionsfolie (1) mit wenigstens zwei Armen (1d) nach außen erstreckt, wobei die Adhäsionsfolie (1) mit einem außen liegenden Bereich am Handhabungselement befestigt ist.

2. Vorrichtung nach Anspruch 1, **dadurch gekennzeichnet, dass** die Adhäsionsfolie (1) eine Spiralform aufweist, insbesondere als wenigstens zwei einander umgebende Spiralarme (1d), deren äußere Enden (3) am Handhabungselement (6) befestigt sind.

3. Vorrichtung nach Anspruch 1 oder 2, **dadurch gekennzeichnet, dass** sich die Arme (1 d) der Adhäsionsfolie (1) von innen nach aussen verbreitern.

4. Vorrichtung nach einem der vorherigen Ansprüche, **dadurch gekennzeichnet, dass** die Adhäsionsfolie (1) perforiert ist, insbesondere zum Zweck der Luftverdrängung beim Anlegen der Adhäsionsfolie (1) an die Oberfläche eines Gegenstandes (2) oder gas- / luftdurchlässig ist oder durch deren Dicke hindurchgehende Kanäle aufweist und im Oberflächenbereich eines flächig ausgebildeten Körpers (6) des Handhabungselementes ein Unterdruck erzeugbar ist, der durch die Adhäsionsfolie / Trägerfolie (1) im plan angelegten Zustand hindurchwirkt.

5. Vorrichtung nach einem der vorherigen Ansprüche, **dadurch gekennzeichnet, dass** die Adhäsionsfolie (1) von dem Handhabungselement (6) mit einer zumindest eindimensionalen Wölbung nach außen vorsteht, insbesondere so, dass die Adhäsionsfolie (1) mit dem Handhabungselement (6) an die Oberfläche eines Gegenstandes (2) unter fortschreitender Vergrößerung der Kontaktfläche, insbesondere abrollend, anlegbar ist.

6. Vorrichtung nach Anspruch 5, **dadurch gekennzeichnet, dass** die Wölbung erzeugt ist durch eine Unterstützung des inneren Bereiches der Adhäsionsfolie (1) mittels eines Stützelementes (15) oder durch eine die Adhäsionsfolie (1) von außen stauchende Kraft.

7. Vorrichtung nach einem der vorherigen Ansprüche 5 oder 6, **dadurch gekennzeichnet, dass** das Handhabungselement (6) auf der konkaven Seite der Wölbung angeordnet ist und die Adhäsionsfolie (1) von hinten, zumindest in einem an die Oberfläche eines Gegenstandes (2) angelegten Zustand stützt.

8. Vorrichtung nach einem der vorherigen Ansprüche, **dadurch gekennzeichnet, dass** das Handhabungselement (6) als ein flächiger Körper ausgebildet ist, der von der Adhäsionsfolie (1) oder einer Trägerfolie, welche eine Adhäsionsfolie (1) trägt, überspannt ist, insbesondere mit einer zumindest eindimensionalen Wölbung überspannt ist.

9. Vorrichtung nach Anspruch 8, **dadurch gekennzeichnet, dass** das Handhabungselement (6) als flächiger Körper mit einer eckigen Grundform, insbesondere mit einer geraden Anzahl von Ecken, ausgebildet ist und die Adhäsionsfolie (1) oder die Trägerfolie derselben im Bereich von wenigstens zwei, insbesondere einander gegenüberliegenden Kanten (6c) des Körpers (6) an/in diesem, insbesondere beweglich befestigt ist, insbesondere wobei die Folie (1) eine wenigstens zweidimensionale Wölbung aufweist.

10. Vorrichtung nach Anspruch 9, **dadurch gekennzeichnet, dass** die Adhäsionsfolie (1) oder eine diese tragende Trägerfolie zur Oberfläche des flächigen Körpers (6) anlagefrei ist, insbesondere ausgenommen im Bereich der Kanten.

11. Vorrichtung nach Anspruch 9 oder 10, **dadurch gekennzeichnet, dass** die den flächigen Körper (6) überspannende Adhäsionsfolie (1) oder Trägerfolie der Adhäsionsfolie (1) ausgehend von einem zusammenhängenden mittleren Bereich (1 c) eine der Anzahl der Ecken des Körpers (6) entsprechende Anzahl von Armen (1d) aufweist, die sich, insbesondere verbreiternd, in die Richtung einer jeweiligen Kante (1d) erstrecken.

12. Vorrichtung nach Anspruch 11, **dadurch gekennzeichnet, dass** die Adhäsions- und/oder Trägerfolie am äußeren Ende der Arme (1d) lappenförmige Endbereiche (1e) aufweist, die jeweils zumindest um die jeweilige Kante (6c) der Oberfläche und/oder Unterfläche des Körpers (6) herumgebogen und im Bereich der Kante (6c) oder im Körper (6) mit dem Körper (6), insbesondere beweglich verbunden sind.

13. Vorrichtung nach Anspruch 11 oder 12, **dadurch gekennzeichnet, dass** die Adhäsions- und/oder Trägerfolie jeweils am äußeren Ende der Arme (1d), insbesondere in den lappenförmigen Endbereichen (1e) wenigstens ein, bevorzugt zwei Gelenke / Scharniere (12) mit parallelen Achsen aufweist, insbesondere wobei die Achsen parallel jeweils zu einer Kante (6c) des Körpers (6) des Handhabungselementes verlaufen.

14. Vorrichtung nach Anspruch 13, **dadurch gekennzeichnet, dass** ein Gelenk / Scharnier (12) ausgebildet ist
a. als eine Materialverdünnung in der Adhäsions- / Trägerfolie (1) oder in einem damit verbundenen Element (13) oder
b. mittels eines flexiblen Gewebes (14) oder einer flexiblen Folie (14), welche/s hinter / unter einer Adhäsions-fTrägerfolie (1) und einem separaten Element (13) und/oder hinter / unter zwei benachbarten separaten Elementen (13) angeordnet ist.

15. Vorrichtung nach einem der vorherigen Ansprüche 12 bis 14, **dadurch gekennzeichnet, dass** die Enden, insbesondere lappenförmigen Enden (1e) alle untereinander mittels einer Hebel- und/oder Getriebemechanik (9, 10a, 10b, 11) verbunden sind, mittels der auf allen Enden gleichzeitig die gleiche Schub- oder Zugkraft ausübbar ist, die durch die Bewegung mindestens eines der lappenförmigen Enden (1e) relativ zum Handhabungselement (6) betätigt ist, insbesondere wobei die Hebel- und/oder Getriebemechanik (9, 10a, 10b, 11) im Inneren des Handhabungselementes (6) angeordnet ist und die lappenförmigen Enden (1e) durch Schlitze (7) in den seitlichen Stirnseiten in das Innere des Handhabungselementes (6) eingeführt und mit der Mechanik (9, 10a, 10b, 11) verbunden sind.

## Claims

1. Apparatus for handling articles with planar, in particular smooth, surfaces and comprising a handling element (6), on which an adhesion sheet (1) is fastened (3) in certain regions and is arranged loosely in certain regions, and therefore the adhesion sheet (1) can be removed from the surface of an article (2) by a movement of the handling element (6) in a direction perpendicular to the surface of the article (2), with the contact surface area decreasing in size progressively, **characterized in that** the adhesion sheet (1) has an inner region (1c) which is loose in relation to the handling element (6) and from which the adhesion sheet (1) extends outwards by way of at least two arms (1d), wherein the adhesion sheet (1) has an outer region fastened on the handling element.

2. Apparatus according to Claim 1, **characterized in that** the adhesion sheet (1) is helical, in particular is in the form of at least two enclosing helical arms (1d), of which the outer ends (3) are fastened on the handling element (6).

3. Apparatus according to Claim 1 or 2, **characterized in that** the arms (1d) of the adhesion sheet (1) widen outwards from the inside.

4. Apparatus according to one of the preceding claims, **characterized in that** the adhesion sheet (1) is perforated, in particular for air-displacement purposes when the adhesion sheet (1) is placed in position on the surface of an article (2), or is gas-permeable/air-permeable or has channels passing through its thickness and, in the surface region of a flat body (6) of the handling element, it is possible to generate a negative pressure which acts through the adhesion sheet/carrier sheet (1) when the latter has been placed in position in the planar state.

5. Apparatus according to one of the preceding claims, **characterized in that** the adhesion sheet (1) projects outwards from the handling element (6) with at least one-dimensional curvature, in particular such that the adhesion sheet (1), by way of the handling element (6), can be placed in position, in particular with rolling action, on the surface of an article (2), with the contact surface area increasing in size progressively.

6. Apparatus according to Claim 5, **characterized in that** the curvature is generated by the inner region of the adhesion sheet (1) being supported by means of a supporting element (15) or by a force which compresses the adhesion sheet (1) from the outside.

7. Apparatus according to either of preceding Claims 5 and 6, **characterized in that** the handling element (6) is arranged on the concave side of the curvature and supports the adhesion sheet (1) from the rear, at least in a state in which the latter has been placed in position on the surface of an article (2).

8. Apparatus according to one of the preceding claims, **characterized in that** the handling element (6) is designed as a flat body which is spanned by the adhesion sheet (1) or a carrier sheet, which carries an adhesion sheet (1), in particular is spanned by at least one-dimensional curvature.

9. Apparatus according to Claim 8, **characterized in that** the handling element (6) is designed as a flat body of polygonal basic shape, in particular with an even number of corners, and the adhesion sheet (1) or the carrier sheet of the same is fastened, in particular in a moveable manner, on/in the body (6) in the region of at least two, in particular mutually opposite edges (6c) of the same, in particular wherein the sheet (1) has at least two-dimensional curvature.

10. Apparatus according to Claim 9, **characterized in that** the adhesion sheet (1) or a carrier sheet carrying the same is abutment-free in relation to the surface of the flat body (6), in particular is cut away in the region of the edges.

11. Apparatus according to Claim 9 or 10, **characterized in that** the adhesion sheet (1), or carrier sheet of the adhesion sheet (1), spanning the flat body (6), starting from a continuous central region (1c), has a number of arms (1d) which corresponds to the number of corners of the body (6), these arms extending, in particular widening, in the direction of a respective edge (1d).

12. Apparatus according to Claim 11, **characterized in that** the adhesion sheet and/or carrier sheet, at the outer end of the arms (1d), has lug-like end regions (1e) which are bent in each case at least around the respective edge (6c) of the upper surface and/or lower surface of the body (6) and are connected to the body (6), in particular in a moveable manner, in the region of the edge (6c) or in the body (6).

13. Apparatus according to Claim 11 or 12, **characterized in that** the adhesion sheet and/or carrier sheet, in each case at the outer end of the arms (1d), in particular in the lug-like end regions (1e), has at least one articulation/hinge (12), preferably two articulations/hinges (12) with parallel axes, in particular wherein the axes run parallel in each case to an edge (6c) of the body (6) of the handling element.

14. Apparatus according to Claim 13, **characterized in that** an articulation/hinge (12) is designed
a. as a thinned material portion in the adhesion sheet/carrier sheet (1) or in an element (13) connected thereto, or
b. by means of a flexible woven fabric (14) or of a flexible sheet (14), which is arranged behind/beneath an adhesion sheet/carrier sheet (1) and a separate element (13) and/or behind/beneath two adjacent separate elements (13).

15. Apparatus according to one of preceding Claims 12 to 14, **characterized in that** the ends, in particular lug-like ends (1e), are all connected to one another by means of a lever mechanism and/or gear mechanism (9, 10a, 10b, 11), by means of which all the ends can be subjected, at the same time, to the same shear or tensile force actuated by the movement of at least one of the lug-like ends (1e) relative to the handling element (6), in particular wherein the lever mechanism and/or gear mechanism (9, 10a, 10b, 11) is arranged in the interior of the handling element (6) and the lug-like ends (1e) are introduced into the interior of the handling element (6), and connected to the mechanism (9, 10a, 10b, 11), through slots (7) in the lateral end sides.

## Revendications

1. Dispositif de manipulation d'objets présentant des surfaces planes et en particulier des surfaces lisses, le dispositif présentant
un élément de manipulation (6) sur lequel une feuille adhésive (1) est fixée (3) en certaines parties et est laissée lâche en d'autres, de telle sorte que la feuille adhésive (1) puisse être enlevée de la surface d'un objet (2) en déplaçant l'élément de manipulation (6) perpendiculairement à la surface de l'objet (2) et en diminuant ainsi progressivement la surface de contact, **caractérisé en ce que**
la feuille adhésive (1) présente une partie intérieure (1c) qui est lâche par rapport à l'élément de manipulation (6) et depuis laquelle la feuille adhésive (1) s'étend vers l'extérieur par au moins deux bras (1d), la feuille adhésive (1) étant fixée sur l'élément de manipulation par une partie située à l'extérieur.

2. Dispositif selon la revendication 1, **caractérisé en ce que** la feuille adhésive (1) présente la forme d'une spirale et en particulier la forme d'au moins deux bras de spirale (1d) qui s'enroulent l'un autour de l'autre et dont les extrémités extérieures (3) sont fixées sur l'élément de manipulation (6).

3. Dispositif selon les revendications 1 ou 2, **caractérisé en ce que** les bras (1d) de la feuille adhésive (1) s'élargissent de l'intérieur vers l'extérieur.

4. Dispositif selon l'une des revendications précédentes, **caractérisé en ce que** la feuille adhésive (1) est perforée, en particulier pour refouler de l'air lors de l'application de la feuille adhésive (1) sur la surface d'un objet (2), est étanche au gaz ou à l'air ou présente des canaux qui traversent son épaisseur, une dépression qui agit à travers la feuille adhésive et/ou feuille de support (1) en position posée à plat pouvant être établie dans la partie de surface d'un corps (6) de configuration aplatie de l'élément de manipulation.

5. Dispositif selon l'une des revendications précédentes, **caractérisé en ce que** la feuille adhésive (1) déborde vers l'extérieur de l'élément de manipulation (6) par une courbure au moins unidimensionnelle, en particulier de telle sorte que la feuille adhésive (1) puisse être appliquée par l'élément de manipulation (6) sur la surface d'un objet (2) par augmentation progressive de la surface de contact, en particulier par déroulement.

6. Dispositif selon la revendication 5, **caractérisé en ce que** la courbure est formée par le fait que la partie intérieure de la feuille adhésive (1) est soutenue au moyen d'un élément de soutien (15) ou par une force qui repousse la feuille adhésive (1) depuis l'extérieur.

7. Dispositif selon l'une des revendications 5 ou 6 précédentes, **caractérisé en ce que** l'élément de manipulation (6) est disposé sur le côté concave de la courbure et soutient la feuille adhésive (1) par l'arrière au moins lorsqu'elle est en position appliquée sur la surface d'un objet (2).

8. Dispositif selon l'une des revendications précédentes, **caractérisé en ce que** l'élément de manipulation (6) est configuré comme corps aplati recouvert par la feuille adhésive (1) ou une feuille de support qui porte une feuille adhésive (1), et en particulier recouvert avec une courbure au moins unidimensionnelle.

9. Dispositif selon la revendication 8, **caractérisé en ce que** l'élément de manipulation (6) est configuré comme corps aplati présentant une forme de base polygonale qui présente en particulier un nombre pair de sommets, la feuille adhésive (1) ou la feuille de support de cette dernière étant fixées sur ou dans ce corps, en particulier à déplacement, au niveau d'au moins deux arêtes (6c) du corps (6), en particulier deux arêtes mutuellement opposées, la feuille (1) présentant en particulier une courbure au moins bidimensionnelle.

10. Dispositif selon la revendication 9, **caractérisé en ce que** la feuille adhésive (1) ou une feuille de support qui la porte sont libres de se placer sur la surface du corps aplati (6), en particulier hors de la zone des arêtes.

11. Dispositif selon les revendications 9 ou 10, **caractérisé en ce que** partant d'une partie centrale continue (1c), la feuille adhésive (1) ou la feuille de support de la feuille adhésive (1) qui recouvre le corps aplati (6) présentent un nombre de bras (1d) qui correspond au nombre des sommets du corps (6), chaque bras s'étendant, en particulier en s'évasant, dans la direction d'une arête respective (1d).

12. Dispositif selon la revendication 11, **caractérisé en ce qu'**à l'extrémité extérieure des bras (1d), la feuille adhésive et/ou la feuille de support présentent des parties d'extrémité (le) en forme de patte qui sont chacune rabattues au moins autour de l'arête concernée (6c) de la surface et/ou de la surface inférieure du corps (6) et sont reliées au corps (6) en particulier à déplacement, au niveau de l'arête (6c) ou dans le corps (6).

13. Dispositif selon les revendications 11 ou 12, **caractérisé en ce qu'**en particulier dans les parties d'extrémité (le) en forme de patte, la feuille adhésive et/ou la feuille de support présentent chacune à l'extrémité extérieure des bras (1d) au moins une et de préférence deux articulations ou charnières (12) à axes parallèles, les axes s'étendant en particulier chacun parallèlement à une arête (6c) du corps (6) de l'élément de manipulation.

14. Dispositif selon la revendication 13, **caractérisé en ce qu'**une articulation ou charnière (12) est configurée :
a. comme amincissement du matériau de la feuille adhésive ou de support (1) ou d'un élément (13) qui leur est relié ou
b. comme tissu flexible (14) ou feuille flexible (14) qui sont disposés en arrière ou en dessous d'une feuille adhésive ou de support (1) et d'un élément séparé (13) et/ou en arrière ou en dessous de deux éléments (13) séparés voisins.

15. Dispositif selon l'une des revendications 12 à 14, **caractérisé en ce que** les extrémités, en particulier les extrémités (le) en forme de patte, sont toutes reliées les unes aux autres au moyen d'un mécanisme à levier et/ou à transmission (9, 10a, 10b, 11) au moyen duquel la même force de poussée ou de traction peut être exercée simultanément sur toutes les extrémités,
cette force étant provoquée par le déplacement d'au moins l'une des extrémités (le) en forme de patte par rapport à l'élément de manipulation (6),
le mécanisme à levier et/ou à transmission (9, 10a, 10b, 11) étant disposé à l'intérieur de l'élément de manipulation (6) et les extrémités (le) en forme de patte étant insérées à l'intérieur de l'élément de manipulation (6) par des fentes (7) ménagées dans les côtés frontaux latéraux et étant reliées au mécanisme (9, 10a, 10b, 11).
